# FASCICULE DE BREVET EUROPEEN

(11) **EP 2 788 779 B1**
(45) Date de publication et mention de la délivrance du brevet: **19.09.2018**
(21) Numéro de dépôt: 12810375.1
(22) Date de dépôt: 07.12.2012
(51) Int. Cl.: G01R 31/28, G01R 1/04, G01R 31/04, G01R 1/073

(54) **DISPOSITIF DE CONTROLE DE CARTES ELECTRONIQUES**
VORRICHTUNG ZUR ÜBERPRÜFUNG ELEKTRONISCHER KARTEN
DEVICE FOR CHECKING ELECTRONIC CARDS

(30) Priorité: 07.12.2011 FR 1161298
(43) Date de publication de la demande: 15.10.2014
(73) Titulaire: Larisys Industries, 67220 Neuve Eglise (FR)
(72) Inventeur: MAHDJOUB, Morad, F-25200 Montbeliard (FR); CHARRIER, Marjorie, F-25400 Audincourt (FR); CONSTANT, Céline, F-90140 Recouvrance (FR)
(74) Mandataire: Rhein, Alain
(86) Numéro de dépôt international: PCT/FR2012/052842
(87) Numéro de publication internationale: WO 2013/083933

(56) Documents cités:
- EP-A1- 0 256 368
- EP-A1- 1 995 602
- FR-A1- 2 842 607
- KR-A- 970 002 353
- US-A- 5 150 041
- US-A- 5 572 144
- US-A- 5 894 225
- US-A1- 2004 178 815
- US-A1- 2007 152 694
- US-A1- 2008 054 910
- US-A1- 2008 197 868
- US-B1- 7 400 135

## Description

L'invention concerne le domaine du contrôle de cartes électroniques.

Elle concerne plus particulièrement un banc de test de cartes électroniques.

La fabrication de cartes électroniques, ou circuits imprimés se fait généralement à partir de résine époxy ou de fibre de verre, sur laquelle on dépose des deux côtés une fine couche de cuivre recouverte d'un vernis photosensible. Une insoleuse permet de « dessiner » le circuit, en sensibilisant le vernis aux endroits choisis. Le vernis sensibilisé est alors retiré, ce qui permet d'attaquer chimiquement le cuivre aux mêmes endroits, et d'obtenir ainsi des circuits électriques entre divers points de la carte. Après retrait du vernis, on peut alors procéder à l'assemblage des composants.

Il est généralement requis de procéder alors à un contrôle fonctionnel de ces cartes. Cela nécessite de vérifier la conformité de passage de courant, de valeurs de courant, ou de barrière au courant entre divers points. Ces contrôles peuvent bien entendu se faire manuellement, mais nécessitent alors beaucoup de temps.

On connaît de l'état de la technique des dispositifs de contrôle 1 comportant une base 2 dans laquelle sont implantés des aiguilles 3, ou clous conducteurs, pointe vers le haut. La carte 4 à contrôler est posée sur les clous de manière appropriée, les clous venant chacun au contact d'un point du circuit électrique de la carte électronique. Le dispositif comprend en outre un couvercle 5, mobile en rotation autour d'une charnière 6, et muni également de clous, pointe vers le bas. En refermant le couvercle, les clous du couvercle viennent au contact du dessus de la carte électronique. La carte électronique peut alors être testée intégralement, par une gestion électronique de contacts, ou de tension entre les différents clous, ainsi qu'une gestion des mesures des réactions renvoyées par la carte électronique.

Néanmoins, l'ouverture du couvercle nécessite un mouvement du couvercle dans une zone étendue au-dessus du dispositif. Du fait de la présence possible d'opérateurs dans cette zone, le mouvement d'ouverture et de fermeture doit être lent, pour limiter au mieux le risque d'accident. De plus un contrôle automatique de présence de mains dans toute la zone balayée par le couvercle lors de sa fermeture ou son ouverture est assez délicat. Par ailleurs, le mouvement du couvercle est généralement commandé par un vérin. Ce vérin peut être proche de la charnière, mais alors l'effort appliqué est important, et cela nécessite un vérin puissant, et donc cher et encombrant, ou alors on dispose le vérin plus loin de la charnière, et l'effort est plus faible, mais alors c'est la course qui est plus importante, et le vérin est encore cher et encombrant. Par ailleurs le mouvement de rotation du couvercle induit une composante horizontale du mouvement des clous, même au moment où ils entrent en contact avec la carte, ce qui nuit à la fiabilité du test d'une part, et produit des effets d'usure sur les clous et/ou les cartes testées.

Le document US 5,150,041 divulgue un dispositif de test d'une plaque d'un circuit imprimé aligné optiquement et présentant des structures de test avec des clous et ayant des moyens de translation.

La présente invention se propose de remédier à au moins une partie des inconvénients précités et propose une solution qui permette de contrôler des cartes électroniques avec un dispositif peu encombrant, avec lequel la sécurité est plus simple à assurer.

A cet effet, l'invention concerne un dispositif de contrôle de cartes électroniques tel que décrit dans la revendication 1, ce dispositif comprenant une base dans laquelle sont disposés des clous conducteurs, pointe vers le haut, et un couvercle, muni également de clous, pointe vers le bas en position couvercle fermé. Le dispositif est particulier en ce que ledit couvercle est mobile en translation horizontale entre une position d'ouverture et une position intermédiaire, et que ledit dispositif comprend un moyen de translation verticale apte à rapprocher les clous disposés dans le couvercle des clous disposés dans la base de sorte à permettre un contact desdits clous sur les deux faces d'une carte électronique.

L'avantage de la présente invention est qu'en éliminant le mouvement de rotation du couvercle, on obtient un encombrement plus faible, et une zone de danger bien plus petite, et plus facile à contrôler et sécuriser. Par ailleurs la précision du positionnement des clous sur la carte est améliorée.

Selon d'autres caractéristiques :
- ledit moyen peut être un moyen de translation verticale du couvercle entre ladite position intermédiaire et une position de fermeture, permettant ainsi de simplifier la conception de la base d'un côté, et du couvercle de l'autre, en disposant les mouvements à l'interface entre la base et le couvercle,
- la base peut comporter une platine de base, et ledit moyen être un moyen de translation verticale de ladite platine entre une position de repos et une position de travail, lesdits clous disposés dans la base étant disposés sur ladite platine de base ; une telle disposition permet de bien séparer les mouvements, et de limiter le couvercle à un mouvement horizontal,
- le couvercle peut comporter une platine de couvercle, et ledit moyen être un moyen de translation verticale de ladite platine entre une position de repos et une position de travail, les clous du couvercle étant disposés sur ladite platine de couvercle ; une telle disposition permet de simplifier le couvercle en limitant les pièces en mouvement vertical, et la base en supprimant tout mouvement dans la base,
- ledit dispositif peut comprendre un mécanisme à crémaillère apte à assurer une translation sensiblement horizontale du couvercle ; une telle disposition permet d'obtenir un mécanisme simple et fiable pour ce mouvement,
- ledit dispositif peut comprendre des vérins aptes à assurer une translation ascendante ou descendante du couvercle, respectivement de la platine ; une telle solution est là encore simple à mettre en oeuvre, et très fiable,

La présente invention concerne également un procédé de fermeture d'un dispositif selon l'invention, comme décrit dans la revendication 7, dans lequel une carte électronique à contrôler a été disposée, comprenant les étapes suivantes :
- contrôle de l'absence d'obstacle sur la trajectoire du couvercle
- translation sensiblement horizontale du couvercle
- translation sensiblement vertical rapprochant les clous du couvercle ou de la base de la carte électronique, de sorte à permettre son contrôle.

La présente invention concerne enfin un procédé d'ouverture d'un dispositif selon l'invention, comme décrit dans la revendication 8, après contrôle d'une carte électronique, comprenant les étapes suivantes :
- écartement vertical des clous du couvercle et de la base jusqu'à ce que les clous du couvercle ne touchent plus la carte électronique,
- translation sensiblement horizontale du couvercle vers sa position d'ouverture.

L'avantage de la présente invention réside en particulier en ce que le mouvement du couvercle est un mouvement de translation, ce qui occasionne moins d'encombrement, facilite la gestion de la sécurité de l'opérateur, et améliore la précision du positionnement. Cela permet également d'aller plus vite et d'augmenter les cadences, et/ou simplifier certaines dispositions comme les ressorts de clous.

D'autres caractéristiques et avantages de l'invention ressortiront de la description détaillée qui va suivre se rapportant à un exemple de réalisation donné à titre indicatif et non limitatif.

La compréhension de cette description sera facilitée en se référant aux dessins joints, dans lesquels :
- la figure 1 représente une vue de côté d'un dispositif selon l'état de la technique en position d'ouverture ;
- la figure 2 représente une vue de côté d'un dispositif selon l'état de la technique en position de fermeture ;
- la figure 3 représente une vue de côté d'un dispositif selon l'invention en position d'ouverture ;
- la figure 4 représente une vue de côté du dispositif de la fig. 1 en position intermédiaire ;
- la figure 5 représente une vue de côté du dispositif de la fig. 1 en position de fermeture ;
- la figure 6 représente une vue de côté d'un autre mode de réalisation d'un dispositif selon l'invention en position de fermeture ;

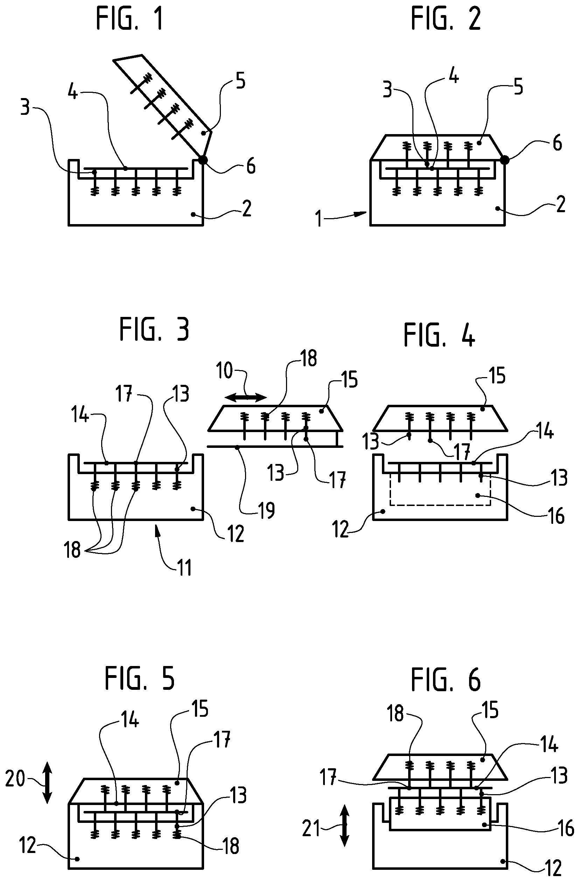

Tel que représenté dans les figures 3 à 6 du dessin ci-joint, la présente invention concerne un dispositif 11 de contrôle de cartes électroniques 14. Le dispositif 11 comporte une base 12 munie de clous ou aiguilles 13 disposées pointes 17 vers le haut. Le dispositif 11 comprend en outre un couvercle 15, également muni de clous 13, mais disposés pointes 17 vers le bas. Les clous 13 sont montés sur la base 12 ou le couvercle 15 par l'intermédiaire de ressorts 18, dont la fonction est d'exercer un effort d'application de la pointe 17 sur la carte 14 à contrôler. Un tel effort d'application est nécessaire pour permettre un bon passage du courant électrique de contrôle entre les clous 13 et le circuit électrique de la carte électronique 14.

Le couvercle 15 est mobile en translation selon un mouvement sensiblement horizontal 10 représenté par une flèche sur la fig. 3, entre une position d'ouverture représentée à la fig. 3 et une position intermédiaire représentée à la fig. 4. Ce mouvement 10 peut être réalisé grâce à une crémaillère 19 représentée de manière schématique à la fig. 3. Bien évidemment ce n'est là qu'une solution parmi toutes les solutions que l'homme du métier pourrait apporter pour réaliser un tel mouvement sensiblement horizontal 10 du couvercle 15.

Selon un mode de réalisation de l'invention, le couvercle 15 est également mobile en translation selon un mouvement sensiblement vertical 20 représenté par une flèche sur la fig. 5, entre la position intermédiaire représentée à la fig. 4 et une position de fermeture représentée à la fig. 5. Ce mouvement peut être réalisé grâce à des vérins non représentés ayant pour effet de monter ou descendre le couvercle 15 et la crémaillère 19. Là aussi, ce n'est là qu'une solution parmi toutes les solutions que l'homme du métier pourrait apporter pour réaliser un tel mouvement sensiblement vertical 20 du couvercle 15.

Selon un autre mode de réalisation de l'invention, le couvercle 15 est maintenu dans sa position intermédiaire, et les clous 13 de la base 12 sont disposés sur une platine de base 16, mobile en translation selon un mouvement sensiblement vertical 21 représenté par une flèche sur la fig. 6, entre une position de repos représentée en pointillés sur la fig. 4 et une position de travail représentée à la fig. 6. Là encore, le mouvement vertical 21 peut être réalisé par des vérins ayant pour fonction de monter ou descendre la platine de base 16, ou par tout autre moyen. On peut aussi disposer les clous 13 du couvercle 15 sur une platine de couvercle, laquelle est alors seule à descendre, sans mouvement vertical 20 du couvercle 15 lui-même. Une telle disposition permet de réduire la masse en mouvement, et le nombre de pièces en mouvement, et réduire ainsi l'énergie consommée et les coûts de maintenance.

Dans les divers modes de réalisation le mouvement vertical 20, 21 produit le rapprochement, puis le contact entre les pointes 17 des clous 13 du couvercle 15 de la carte électronique 14. Les ressorts 18 assurent un effort d'application des pointes 17 sur la carte 14.

Selon un mode de réalisation avantageux de l'invention, on peut supprimer les ressorts 18 soit dans la base 12 (exemple représenté à la fig. 4), soit dans le couvercle 15 (exemple non représenté). En effet, le mouvement de rapprochement des clous 13 du couvercle 15 vers la carte 14 se fait d'une manière parfaitement alignée, sans aucune composante horizontale du mouvement contrairement au dispositif 1 de l'état de la technique. Cela permet donc une approche bien plus précise, rendant possible un bon contact des pointes 17 sur la carte 14 des deux côtés de la carte 14, même quand dans un seul, de la base 12 et du couvercle 15, les clous 13 sont munis de ressorts 18.

L'utilisation du dispositif 11 s'effectue alors de la manière suivante :
En actionnant une commande d'ouverture, par un bouton poussoir situé sur le dispositif 11, le couvercle 15 se met en position d'ouverture. L'opérateur pose alors la carte électronique 14 à contrôler sur les pointes 17 des clous 13 de la base 12. Des repères, ou gabarits peuvent être prévus, pour aider au parfait positionnement de la carte 14. L'opérateur actionne ensuite une commande de fermeture, par un autre bouton poussoir. Le dispositif 11 comprend des moyens de détection d'un obstacle sur la trajectoire du couvercle 15, ainsi qu'entre le couvercle 15 et la base 12 pendant la trajectoire. Lorsque ces moyens de détection sont activés, il existe un obstacle. Un tel obstacle peut notamment consister en une main de l'opérateur. Il serait alors dangereux pour lui de refermer le couvercle 15 immédiatement. Dès qu'il n'y a plus d'obstacle, le couvercle 15 se met rapidement dans sa position intermédiaire. Un détecteur permet de confirmer que cette position est atteinte, puis, selon le mode de réalisation, le couvercle 15 ou sa platine est abaissé, ou alors la platine de base 16 est relevée, jusqu'au contact entre les pointes 17 des clous 13 du couvercle 15 avec la carte 14. Le dispositif 11 effectue le contrôle, puis engage rapidement les mouvements inverses de levage du couvercle 15 ou de sa platine ou abaissement de la platine de base 16, puis de translation horizontale jusqu'à la position d'ouverture du couvercle 15. La carte électronique 14 peut alors être retirée, et s'il n'y a pas d'autre carte 14 à vérifier immédiatement après, le couvercle 15 peut se refermer.

Bien entendu, d'autres procédures ou contrôles peuvent être prévus ou s'ajouter, selon une expertise habituelle de l'homme du métier, sans sortir pour autant du cadre de la présente invention.

Dans le mode de réalisation avec une platine 16 mobile en translation verticale, le dispositif 11 peut être défini au repos quand le couvercle 15 est en position intermédiaire et la platine de base 16 en position basse, ou alors la platine de couvercle en position haute. On peut alors configurer la base 12 et le couvercle 15 de sorte que dans ces positions le couvercle 15 assure une fermeture suffisamment efficace du dispositif 11 à l'arrêt. Lors d'une commande d'ouverture, le mouvement de translation du couvercle 15 peut démarrer immédiatement, sans nécessiter d'abord un mouvement de translation vertical, ce qui permet d'obtenir que le dispositif 11 est opérationnel plus rapidement.

L'avantage de la présente invention réside en particulier en ce que le mouvement du couvercle 15 est un mouvement de translation, ce qui occasionne moins d'encombrement, facilite la gestion de la sécurité de l'opérateur, et améliore la précision du positionnement. Cela permet également d'aller plus vite et d'augmenter les cadences, et/ou simplifier certaines dispositions comme les ressorts 18 de clous 13.

## Revendications

1. Dispositif (11) de contrôle de cartes électroniques (14), ce dispositif (11) comprenant :
- une base (12) dans laquelle sont disposés des clous (13) conducteurs, pointe (17) vers le haut ;
- une structure (15) étant munie également de clous (13), pointe (17) vers le bas, ladite structure (15); et
- un moyen de translation verticale (20, 21) apte à rapprocher les clous (13) disposés dans la structure (15) des clous (13) disposés dans la base (12) de sorte à permettre un contact desdits clous (13) sur les deux faces d'une carte électronique (14),
**caractérisé en ce que** ladite structure est un couvercle (15) de fermeture du dispositif (11), lesdits clous (13) étant pointe (17) vers le bas en position couvercle (15) fermé, ledit couvercle (15) étant mobile en translation horizontale (10) entre une position d'ouverture du dispositif (11) et une position intermédiaire.

2. Dispositif (11) selon la revendication précédente, dans lequel ledit moyen est un moyen de translation verticale (20) du couvercle (15) entre ladite position intermédiaire et une position de fermeture.

3. Dispositif (11) selon la revendication 1, dans lequel la base (12) comporte une platine de base (16), et ledit moyen est un moyen de translation verticale (21) de ladite platine de base (16) entre une position de repos et une position de travail, lesdits clous (13) disposés dans la base (12) étant disposés sur ladite platine de base (16).

4. Dispositif (11) selon la revendication 1, dans lequel le couvercle (15) comporte une platine de couvercle, et ledit moyen est un moyen de translation verticale de ladite platine entre une position de repos et une position de travail, les clous (13) du couvercle (15) étant disposés sur ladite platine de couvercle.

5. Dispositif (11) selon la revendication précédente, comprenant un mécanisme à crémaillère (19) apte à assurer une translation sensiblement horizontale du couvercle (15).

6. Dispositif (11) selon l'une des revendications précédentes, comprenant des vérins aptes à assurer une translation ascendante ou descendante du couvercle (15), respectivement de la platine de base (16) ou de couvercle.

7. Procédé de fermeture d'un dispositif (11) selon l'une des revendications précédentes, dans lequel une carte électronique (14) à contrôler a été disposée, comprenant les étapes suivantes :
- contrôle de l'absence d'obstacle sur la trajectoire du couvercle (15) ;
- translation sensiblement horizontale du couvercle (15) d'une position d'ouverture du dispositif (11) vers une position intermédiaire ;
- translation sensiblement verticale (20, 21) rapprochant les clous (13) du couvercle (15) de la carte électronique (14), de sorte à permettre son contrôle.

8. Procédé d'ouverture d'un dispositif (11) selon l'une des revendications 1 à 6 après contrôle d'une carte électronique (14), comprenant les étapes suivantes :
- écartement vertical (20, 21) des clous (13) du couvercle (15) et de la base (12) jusqu'à ce que les clous (13) du couvercle (15) ne touchent plus la carte électronique (14),
- translation sensiblement horizontale du couvercle (15) vers la position d'ouverture du dispositif (11).

## Patentansprüche

1. Vorrichtung (11) zur Überprüfung elektronischer Karten (14), bei der diese Vorrichtung (11) Folgendes umfasst :
- eine Basis (12), in der leitende Nägel (13) mit der Spitze (17) nach oben angeordnet sind ;
- eine Struktur (15), die ebenfalls mit Nägeln (13) mit der Spitze (17) nach unten versehen ist, wobei die besagte Struktur (15) horizontal translationsbeweglich (10) ist ; und
- ein vertikales Translationsmittel (20, 21), das in der Lage ist, die in der Struktur (15) angheordneten Nägel (13) so nahe an die in der Basis (12) angeordneten Nägel (13) zu bringen, dass eine Berührung der besagten Nägel (13) mit beiden Seiten einer elektronischen Karte (14) erlaubt wird,
**dadurch gekennzeichnet, dass** die besagte Struktur ein Deckel (15) zum Schließen der Vorrichtung (11) ist, wobei sich die Nägel (13) in geschlossener Position des Deckels (15) mit der Spitze (17) nach unten befinden, wobei der Deckel (15) horizontal translationsbeweglich (10) zwischen einer offenen Position der Vorrichtung (11) und einer Zwischenposition ist.

2. Vorrichtung (11) nach dem vorhergehenden Anspruch, bei der das besagte Mittel ein Mittel zur vertikalen Translationsverschiebung (20) des Deckels (15) zwischen der besagten Zwischenposition und einer geschlossenen Position ist.

3. Vorrichtung (11) nach Anspruch 1, bei der die Basis (12) eine Basisplatte (16) umfasst und das besagte Mittel ein Mittel zur vertikalen Translationsverschiebung (21) der besagten Basisplatte (16) zwischen einer Ruheposition und einer Arbeitsposition ist, wobei die besagten in der Basis (12) angeordneten Nägel (13) auf der besagten Basisplatte (16) angeordnet sind.

4. Vorrichtung (11) nach Anspruch 1, bei der der Deckel (15) eine Deckelplatte umfasst und das besagte Mittel ein Mittel zur vertikalen Translationsverschiebung der besagten Platte zwischen einer Ruheposition und einer Arbeitsposition ist, wobei die Nägel (13) des Deckels (15) auf der besagten Deckelplatte angeordnet sind.

5. Vorrichtung (11) nach dem vorhergehenden Anspruch, umfassend einen Zahnstangenmechanismus (19), der in der Lage ist, eine im Wesentlichen horizontale Translationsverschiebung des Deckels (15) zu sichern.

6. Vorrichtung (11) nach einem der vorhergehenden Ansprüche, umfassend Zylinder, die in der Lage sind, eine Aufwärts- oder Abwärtstranslationsverschiebung des Deckels (15) der Basis- (16) bzw. der Deckelplatte zu sichern.

7. Verfahren zum Verschließen einer Vorrichtung (11) nach einem der vorhergehenden Ansprüche, in dem eine zu überprüfende elektronische Karte (14) angeordnet wurde, umfassend die folgenden Schritte :
- Überprüfung des Fehlens eines Hindernisses auf der Verschiebungsbahn des Deckels (15) ;
- im wesentlichen horizontale Translationsverschiebung des Deckels (15) von einer offenen Position der Vorrichtung (11) zu einer Zwischenposition ;
- im wesentlichen vertikale Translationsverschiebung (20, 21), die die Nägel (13) des Deckels (15) nahe an die elektronische Karte (14) bringt, so dass ihre Überprüfung erlaubt wird.

8. Verfahren zum Öffnen einer Vorrichtung (11) nach einem der Ansprüche 1 bis 6 nach der Überprüfung einer elektronischen Karte (14), umfassend die folgenden Schritte :
- vertikale Entfernung (20, 21) der Nägel (13) des Deckels (15) und der Basis (12), bis die Nägel (13) des Deckels (15) die elektronische Karte (14) nicht mehr berühren ;
- im wesentlichen horizontale Translationsverschiebung des Deckels in die offene Position der Vorrichtung (11).

## Claims

1. A device (11) for checking electronic cards (14), this device (11) comprising :
- a base (12) in which conductive nails (13) are arranged with the tip (17) upwards
- a structure (15) also being provided with nails (13) with the tip (17) downwards, said structure (15) being movable in horizontal translation (10) ; and
- a vertical translation means (20, 21) capable of bringing the nails (13) arranged in the structure (15) close to the nails (13) arranged in the base (12) so as to permit a contact of said nails (13) on both faces of an electronic card (14),
wherein said structure is a lid (15) for closing the device (11), said nails (13) having the tip (17) downwards in the closed position of the lid (15), said lid (15) being movable in horizontal translation (10) between an open position of the device (11) and an intermediate position.

2. The device (11) according to the preceding claim, wherein said means is a means for vertically translating (20) the lid (15) between said intermediate position and a closed position.

3. The device (11) according to claim 1, wherein the base (12) comprises a base plate (16), and said means is a means for vertically translating (21) said base plate (16) between a rest position and a working position, said nails (13) arranged in the base (12) being arranged on said base plate (16).

4. The device (11) according to claim 1, wherein the lid (15) includes a lid plate, and said means is a means for vertically translating said plate between a rest position and a working position, the nails (13) of the lid (15) being arranged on said lid plate.

5. The device (11) according to the preceding claim, comprising a rack mechanism (19) capable of ensuring a substantially horizontal translation of the lid (15).

6. The device (11) according to one of the preceding claims, comprising cylinders capable of ensuring an upward or downward translation of the lid (15) or of the base or lid plate (16), respectively.

7. A method for closing a device (11) according to one of the preceding claims, wherein an electronic card (14) to be checked has been arranged, comprising the following steps :
- checking of the absence of an obstacle on the trajectory of the lid (15) ;
- substantially horizontal translation of the lid (15) from an open position of the device (11) to an intermediate position ;
- substantially vertical translation (20, 21) bringing the nails (13) of the lid (15) close to the electronic card (14), so as to permit its checking.

8. A method for opening a device (11) according to one of claims 1 to 6 after checking an electronic card (14), comprising the following steps :
- vertical separation (20, 21) of the nails (13) of the lid (15) and of the base (12) until the nails (13) of the lid (15) do no longer touch the electronic card (14) ;
- substantially horizontal translation of the lid towards the open position of the device (11).
